# EUROPÄISCHE PATENTSCHRIFT

(11) **EP 1 016 104 B1**
(45) Veröffentlichungstag und Bekanntmachung des Hinweises auf die Patenterteilung: **13.10.2004**
(21) Anmeldenummer: 98947482.0
(22) Anmeldetag: 29.08.1998
(51) Int. Cl.: H01F 38/26

(54) **WANDLERANORDNUNG MIT TRENNEINRICHTUNG**
TRANSFORMER SYSTEM PROVIDED WITH A DECOUPLING SYSTEM
SYSTEME DE TRANSFORMATEUR MUNI D'UN SYSTEME DE DECOUPLAGE

(30) Priorität: 16.09.1997 DE 19740664; 30.03.1998 DE 19814034
(43) Veröffentlichungstag der Anmeldung: 05.07.2000
(73) Patentinhaber: KG Ritz Messwandler GmbH & Co., 22111 Hamburg (DE)
(72) Erfinder: BROCKMANN, Olaf, D-22359 Hamburg (DE); PSCHEIDL, Jörg, D-22415 Hamburg (DE)
(74) Vertreter: Vonnemann, Gerhard, Dr.-Ing.
(86) Internationale Anmeldenummer: PCT/EP1998/005507
(87) Internationale Veröffentlichungsnummer: WO 1999/014772

(56) Entgegenhaltungen:
- EP-A- 0 755 061
- DE-A- 2 356 988
- DE-A- 4 243 207
- PATENT ABSTRACTS OF JAPAN vol. 9, no. 230 (E-343) [1953], 17. September 1985 & JP 60 084809 A (MITSUBISHI)

## Beschreibung

Die Erfindung betrifft eine Wandleranordnung mit einem einen Spannungswandler aufnehmenden Wandlergehäuse und einem mit dem Spannungswandler elektrisch verbundenen, aus dem Wandlergehäuse herausgeführten ersten elektrischen Anschluß zum Anschließen der Wandleranordnung an eine Hochspannungsanlage, wobei im Wandlergehäuse eine von außerhalb des Wandlergehäuses betätigbare Trennvorrichtung zum vorübergehenden Unterbrechen der elektrischen Verbindung zwischen dem Spannungswandler und dem ersten elektrischen Anschluß angeordnet ist

Derartige Wandleranordnungen sind bekannt. Sie werden für die ständige Überwachung der Hochspannung an Hochspannungsanlagen, beispielsweise Schaltanlagen angeschlossen und für gewöhnlich fest montiert. Für Wartungs- oder Prüfzwecke ist es aber erforderlich, die bekannten Wandleranordnungen zu demontieren. Insbesondere für eine an der Hochspannungsanlage durchgeführte Gleichspannungs-Kabelprüfung muß ein induktiver Spannungswandler entfernt werden, weil er sonst bei der Durchführung der Prüfung unweigerlich vollkommen zerstört würde.

Bei vielen Hochspannungsanlagen mit Steckbuchsen zum Anschluß von Hochspannungskabeln und Spannungswandlern muß die bekannte Wandleranordnung auch aus einem anderen Grund demontiert werden. Oft ist an der Schaltanlage keine Steckbuchse zum Anschluß eines Prüfkabels für die Gleichspannungszuführung mehr frei. Der Spannungswandler muß dann schon deshalb demontiert werden, damit das Prüfkabel an die vorher von ihm belegte Steckbuchse angeschlossen werden kann.

Zur Durchführung der Spannungsprüfung sind bei bekannten Anordnungen die folgenden Schritte erforderlich:
- Der Spannungswandler wird demontiert.
- Die freigewordene Steckbuchse wird mit dem Prüfkabel belegt.
- Die Gleichspannungsprüfung wird durchgeführt.
- Das Prüfkabel wird demontiert.
- Der Spannungswandler wird wieder montiert.

Die Durchführung dieser Prozedur ist zeitaufwendig und teuer.

Aus der DE 23 56 988 A ist eine Wandleranordnung bekannt, bei der die Verbindung zwischen dem Hochspannungsanschluß und dem Durchführungsleiter der Hochspannungsdurchführung lösbar ausgestaltet ist. Die lösbare Verbindung dient dazu, eine mechanische Trennung des oberen Durchführungsteils vom unteren Gehäuse des Spannungswandlers zu ermöglichen, damit der Spannungswandler unter Beibehaltung seines gedrängten Aufbaus sowohl für metallgekapselte Hochspannungs-Schaltanlagen als auch für nicht gekapselte Innenraum- oder Freiluftanlagen verwendet werden kann.

Aus der EP-A 0 755 061 ist eine gattungsgemäße Wandleranordnung bekannt, bei der ein erster Hochspannungsanschluß zum Verbinden der Wandleranordnung mit der Hochspannung vorgesehen ist und ein zweiter, zum Verbinden der Wandleranordnung mit dem Erdpotential vorgesehener Anschluß ebenfalls in der Bauform eines Hochspannungsanschlusses ausgeführt ist. Zur Hochspannungsprüfung mit Gleichspannung kann der Erdanschluß der bekannten Wandleranordnung vom Erdpotential getrennt werden, damit der induktive Spannungswandler nicht durch einen ansonsten fließenden Gleichstrom zerstört werden kann.

Aus der DE 42 43 207 A ist eine Wandleranordnung für Hochspannungsanlagen bekannt, bei der die Primärwicklung des Wandlers hochspannungsseitig über einen zum Schaltanlagengehäuse hin gerichteten steckbaren Leiterarm geschlossen ist. Die Steckverbindung ist zwar grundsätzlich lösbar, jedoch ist sie innerhalb des Wandlergehäuses angeordnet und daher ohne Öffnen des Gehäuses nicht von außen zugänglich.

Aus der JP-A 60084809 ist eine Transformatoranordnung bekannt, bei der ein Anschluß des Transformators über eine Sicherung und ein weiteres Leitungselement an einem spannungsführenden Steckanschluß angeschlossen ist.

Aufgabe der vorliegenden Erfindung ist es, eine Wandleranordnung der eingangs genannten Art anzugeben, mit der eine Spannungsprüfung an einer Hochspannungsanlage einfacher durchgeführt werden kann.

Die Aufgabe wird erfindungsgemäß dadurch gelöst, daß das Wandlergehäuse in Gießharz ausgeführt ist, daß die Trennvorrichtung zwei in das Gießharz eingegossene Kontakte und einen Hohlraum aufweist, in dem ein zur elektrischen Verbindung der Kontakte dienendes Brückenelement angeordnet ist.

Damit können alle Bauteile in einem einzigen Arbeitsgang in das Gießharzgehäuse eingegossen werden, wobei die spannungsführenden Teile auch gleich noch elektrisch isoliert werden.

Die erfindungsgemäße Wandleranordnung erlaubt die elektrische Abtrennung des Spannungswandlers von der Hochspannungsanlage, ohne daß eine Demontage erforderlich wäre. Die Gleichspannungsprüfung kann dann ohne Zerstörung des Spannungswandlers durchgeführt werden.

Wenn der erste elektrische Anschluß als Steckkontakt zum Einstecken in eine Steckbuchse einer Hochspannungsanlage und der weitere elektrische Anschluß als Steckbuchse ausgebildet ist, kann die erfindungsgemäße Wandleranordnung auf besonders einfache Weise mit der Hochspannungsanlage und dem Prüfkabel verbunden werden. Dabei ist es hier im Hinblick auf die Kompatibilität besonders zweckmäßig, wenn Steckbuchse und Steckkontakt als Innenkonus gemäß DIN 47637 oder als Außenkonus gemäß DIN 47636 ausgeführt sind.

In Weiterbildung der Erfindung ist vorgesehen, daß der durch eine Einführöffnung des Wandlergehäuses von außen zugängliche Hohlraum konisch und das Brückenelement stabförmig ausgebildet ist, daß die Kontakte an den axialen Enden des Hohlraums angeordnet sind und daß das Brückenelement durch die Einführöffnung hindurch axial in den konischen Hohlraum ein- und ausführbar ist. Auf Grund seiner Stabform ist das Brückenelement auf einfache Weise durch axiales Einstecken in den konischen Hohlraum montierbar. Dabei wird es durch die konische Form des Hohlraums genau auf den hinteren Kontakt hingeführt, an den es angedrückt werden muß.

Wenn die Einführöffnung buchsenförmig, vorzugsweise in Form einer herkömmlichen Hochspannungssteckbuchse, insbesondere nach o.g. DIN-Norm, ausgebildet und mittels eines Deckels verschließbar ist, kann bei Konstruktion und Fertigung auf eine normierte und im anderen Zusammenhang bereits vielfach verwendete und bewährte Formgebung zurückgegriffen werden kann, wodurch die Konstruktions- und Fertigungskosten reduziert werden.

Die Maßnahme, daß in der Einführöffnung zwischen dem Brückenelement und dem Deckel ein Kabelblindstecker angeordnet ist, gewährleistet die Bedingungen für den Berührungsschutz, aufgrund der Hochspannungsfestigkeit des Kabelblindsteckers.

Die Maßnahme, daß das Brückenelement beim Einstecken über ein axial wirkendes Federelement an den gegenüber der Einführöffnung angeordneten, ersten Kontakt andrückbar ist, gewährleistet eine einfache und sichere Kontaktierung beim Einstecken des Brückenelements.

Wenn der an dem der Einführöffnung zugewandten Ende des Hohlraums angeordnete, zweite Kontakt als Kontaktring mit Durchgangsöffnung und axial wirkenden Kontaktelementen ausgebildet ist, kann das Brückenelement problemlos durch den Kontaktring hindurch in den konischen Hohlraum eingeführt werden. Danach wird durch die axial wirkenden Kontaktelemente ein sicherer elektrischer Kontakt hergestellt.

In Weiterbildung der Erfindung ist der Hohlraum im Trennzustand anstatt des entfernten Kabelblindsteckers und Brückenelements mit einem speziellen Blindstecker aus einem elastischen Material versehbar, der den Hohlraum ausfüllt und die beiden Kontakte hochspannungsfest voneinander trennt. Durch diese Maßnahme kann die innere Trennstrecke zwischen den beiden Kontakten auf einen minimalen Abstand reduziert werden, denn der elastische Blindstecker legt sich glatt an die inneren Flächen des Hohlraums und insbesondere auch an die Kontaktflächen an und verdrängt dabei die Luft aus dem Hohlraum. So werden Überschläge verhindert, die ansonsten in dem luftgefüllten Hohlraum zwischen den Kontakten auftreten könnten. Mit dieser Maßnahme verringern sich aber auch die Gesamtabmessungen des Wandlergehäuses, sein Gewicht und die Fertigungskosten.

Die Erfindung kann dadurch noch verbessert werden, daß der Blindstecker mit einem Deckelteil verbunden ist, das statt des Deckels mit dem Wandlergehäuse verschraubbar ist. Der Blindstecker mit Deckelteil gewährleistet aufgrund seiner Hochspannungsfestigkeit die Bedingungen für den Berührungsschutz.

Weitere Vorteile und Einzelheiten der Erfindung ergeben sich aus der nachfolgenden Beschreibung von Ausführungsbeispielen anhand der Zeichnungen.

Die Figuren zeigen im einzelnen:
- Figur 1: ein erstes Ausführungsbeispiel einer erfindungsgemäßen Wandleranordnung im Schnitt;
- Figur 2: dieselbe Wandleranordnung wie in Figur 1, im Trennzustand;
- Figur 3: ein zweites Ausführungsbeispiel einer erfindungsgemäßen Wandleranordnung im Schnitt.

Die in den Figuren dargestellte erfindungsgemäße Wandleranordnung besitzt ein Wandlergehäuse 1 aus Gießharz 2 mit einem Metallmantel 3. Im Wandlergehäuse 1 ist ein induktiver Spannungswandler 4 angeordnet.

Zur elektrischen Verbindung der Wandleranordnung mit einer nicht gezeigten, hochspannungsführenden Steckbuchse einer Hochspannungsanlage ist als ein erster elektrischer Anschluß ein Steckkontakt 6 vorgesehen, der seitlich über das Wandlergehäuse 1 heraussteht. Der Steckkontakt 6 besteht aus einem Isolierteil 7, einem Metallkontakt 8 und einem Leiter 9.

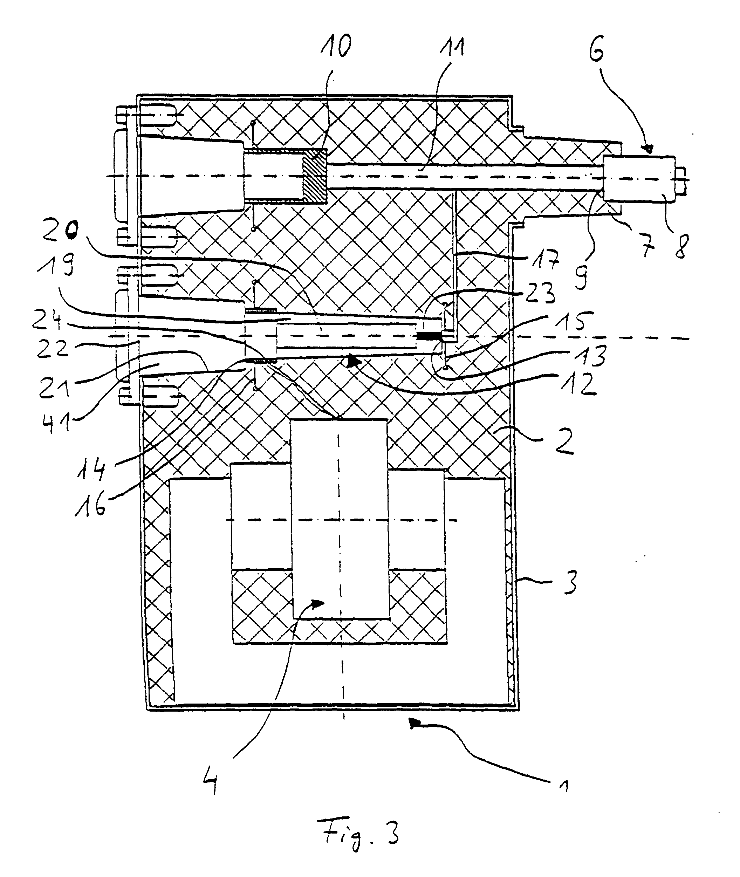

Bei der in Figur 3 dargestellten Ausführungsform ist auf der dem Steckkontakt 6 gegenüberliegenden Seite des Wandlergehäuses 1 als weiterer herausgeführter elektrischer Anschluß eine Steckbuchse 10 angeordnet, die über eine stromtragfähige Verbindung 11 mit dem Leiter 9 des Steckkontakts 6 verbunden ist.

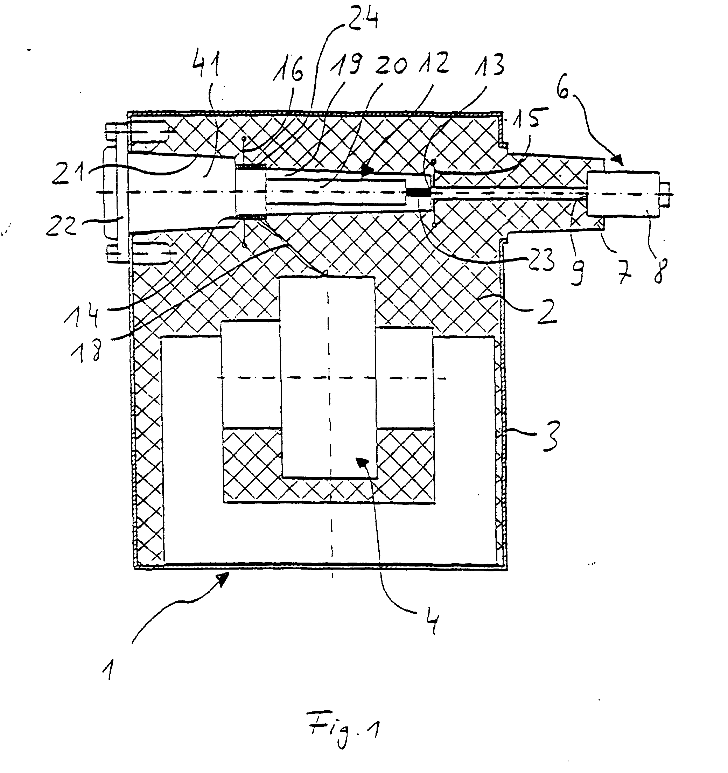

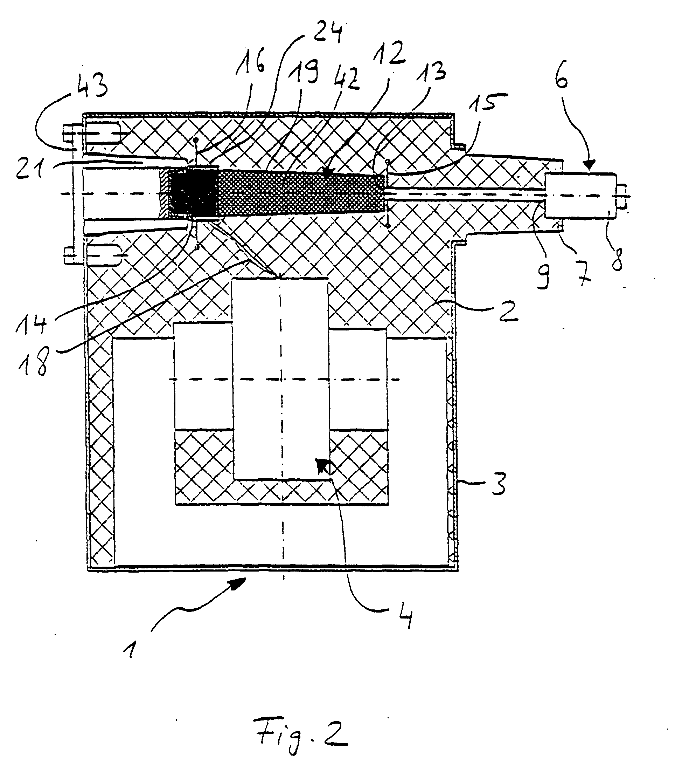

Bei beiden Ausführungsformen ist weiterhin im Wandlergehäuse 1 eine Trennvorrichtung 12 angeordnet, die zwei gegenüberliegende Kontakte 13, 14 aufweist. Die Kontakte sind jeweils mit Feldsteuerelektroden 15, 16 versehen. Der erste Kontakt 13 ist direkt (Figuren 1 und 2) oder indirekt über eine Verbindungsleitung 17 (Figur3) mit dem Leiter 9 des Steckkontakts 6 bzw. der stromtragfähigen Verbindung 11 verbunden. Der zweite Kontakt 14 ist mit der anderen Zuleitung 18 der Spannungswandlers 4 verbunden. Zwischen den beiden Kontakten 13, 14 ist im Gießharz 2 ein konischer Hohlraum 19 ausgebildet, so daß die Kontakte 13, 14 an den axialen Enden des Hohlraums 19 angeordnet sind. Im Hohlraum 19 ist ein zur elektrischen Verbindung der beiden Kontakte 13, 14 dienendes, stabförmiges Brückenelement 20 angeordnet, das hier als zylindrischer Leiter ausgeführt ist, aber z.B. auch aus einer stabförmigen Sicherung bestehen kann.

Der Hohlraum 19 der Trennvorrichtung 12 ist über eine in Form einer herkömmlichen Hochspannungssteckbuchse ausgebildete Einführöffnung 21 von außerhalb des Wandlergehäuses 1 zugänglich. Die Einführöffnung 21 ist mit einem Deckel 22 verschließbar, der von außen auf das Wandlergehäuse 1 aufgeschraubt ist. Bei abgenommenem Deckel 22 kann das Brückenelement 20 durch die Einführöffnung 21 hindurch in den Hohlraum 19 axial eingeführt oder entnommen werden. Danach wird die Einführöffnung 21 mit einem Kabelblindstecker 41 versehen und mit dem Deckel 22 verschlossen. Der Kabelblindstecker 41 gewährleistet aufgrund seiner Hochspannungsfestigkeit die Bedingungen für den Berührungsschutz.

Zwischen dem ersten Kontakt und dem Brückenelement 20 ist ein axial wirkendes Federelement 23 angeordnet, gegen das Brückenelement 20 beim Einführen in den Hohlraum 19 axial angedrückt wird. Dabei wird das Brückenelement 20 durch die konische Form des Hohlraums 19 genau auf den Kontakt 13 hingeführt und so eine sichere elektrische Kontaktierung erzielt. Der zweite Kontakt 14 ist als Kontaktring 24 mit einer Durchgangsöffnung ausgeführt, durch die das Brückenelement 20 hindurchgeschoben wird. In der Endstellung sorgen axial wirkende Kontaktelemente für eine sichere elektrische Verbindung zum Brückenelement 20. Damit ist der Funktionszustand hergestellt.

Zur Herstellung des Trennzustands wird der Kabelblindstecker 41 bei spannungsloser Anlage entfernt und das Brückenelement 20 aus dem Hohlraum 19 gezogen. Danach wird der Hohlraum durch einen speziellen Blindstecker 42 aus einem elastischen Material, vorzugsweise Silikon, ausgefüllt, der die beiden Kontakte 13, 14 hochspannungsfest voneinander trennt (Figur 2). Der Blindstecker 42 ist mit einem Deckelteil 43 verbunden, das statt des Deckels 22 mit dem Wandlergehäuse 1 verschraubt wird. Aufgrund des sich eng an die Kontaktflächen und die Wände des Hohlraums 19 anschmiegenden Blindsteckers 42 kann die innere Trennstrecke zwischen den beiden Kontakten 13, 14 auf einen sehr viel kleineren Abstand reduziert werden als nötig wäre, wenn sich zwischen den Kontakten 13, 14 nur Luft befände. Damit verringern sich aber auch die Gesamtabmessungen des Wandlergehäuses 1, sein Gewicht und die Fertigungskosten. Der Blindstecker 42 mit Deckelteil 43 gewährleistet aufgrund seiner Hochspannungsfestigkeit die Bedingungen für den Berührungsschutz.

### Bezugszeichenliste

- 1: Wandlergehäuse
- 2: Gießharz
- 3: Metallmantel
- 4: Spannungswandler
- 6: Steckkontakt
- 7: Isolierteil
- 8: Metallkontakt
- 9: Leiter
- 10: Steckbuchse
- 11: Verbindung
- 12: Trennvorrichtung
- 13: erster Kontakt
- 14: zweiter Kontakt
- 15: Feldsteuerelektrode
- 16: Feldsteuerelektrode
- 17: Verbindungsleitung
- 18: Zuleitung
- 19: Hohlraum
- 20: Brückenelement
- 21: Einführöffnung
- 22: Deckel
- 23: Federelement
- 24: Kontaktring
- 41: Kabelblindstecker
- 42: Blindstecker
- 43: Deckelteil

## Patentansprüche

1. Wandleranordnung mit einem einen Spannungswandler (4) aufnehmenden Wandlergehäuse (1) und einem mit dem Spannungswandler (4) elektrisch verbundenen, aus dem Wandlergehäuse (1) herausgeführten ersten elektrischen Anschluß (6) zum Anschließen der Wandleranordnung an eine Hochspannungsanlage, wobei im Wandlergehäuse (1) eine von außerhalb des Wandlergehäuses (1) zugängliche Trennvorrichtung (12) zum vorübergehenden Unterbrechen der elektrischen Verbindung zwischen dem Spannungswandler (4) und dem ersten elektrischen Anschluß (6) angeordnet ist, **dadurch gekennzeichnet, daß** das Wandlergehäuse (1) in Gießharz (2) ausgeführt ist, daß die Trennvorrichtung (12) zwei in das Gießharz (2) eingegossene Kontakte (13, 14) und einen Hohlraum (19) aufweist, in den ein zur elektrischen Verbindung der Kontakte (13, 14) dienendes Brückenelement (20) einschiebbar ist.

2. Wandleranordnung nach Anspruch 1, **dadurch gekennzeichnet, daß** der durch eine Einführöffnung (21) des Wandlergehäuses (1) von außen zugängliche Hohlraum (19) konisch und das Brückenelement (20) stabförmig ausgebildet ist, daß die Kontakte (13, 14) an den axialen Enden des Hohlraums (19) angeordnet sind und daß das Brückenelement (20) durch die Einführöffnung (21) hindurch axial in den konischen Hohlraum (19) ein- und ausführbar ist.

3. Wandleranordnung nach Anspruch 2, **dadurch gekennzeichnet, daß** die Einführöffnung (21) buchsenförmig, vorzugsweise in Form einer herkömmlichen Hochspannungssteckbuchse, ausgebildet und mittels eines Deckels (22) verschließbar ist.

4. Wandleranordnung nach Anspruch 3, **dadurch gekennzeichnet, daß** in der Einführöffnung (21) zwischen dem Brückenelement (20) und dem Deckel (22) ein Kabelblindstecker (41) angeordnet ist.

5. Wandleranordnung nach einem der vorhergehenden Ansprüche, **dadurch gekennzeichnet, daß** das Brückenelement (20) beim Einstecken über ein axial wirkendes Federelement (23) an einen gegenüber der Einführöffnung (21) angeordneten, ersten Kontakt (13) der vorgenannten zwei eingegossenen Kontakte (13, 14) andrückbar ist.

6. Wandleranordnung nach einem der vorhergehenden Ansprüche, **dadurch gekennzeichnet, daß** ein an dem der Einführöffnung (21) zugewandten Ende des Hohlraums (19) angeordneter, zweiter Kontakt (14) der vorgenannten zwei eingegossenen Kontakte (13, 14) als Kontaktring (24) mit Durchgangsöffnung und axial wirkenden Kontaktelementen ausgebildet ist.

7. Wandleranordnung nach einem der vorhergehenden Ansprüche, **dadurch gekennzeichnet, daß** der Hohlraum (19) im Trennzustand anstatt des entfernten Kabelblindsteckers (41) und Brückenelements (20) mit einem speziellen Blindstecker (42) aus einem elastischen Material versehbar ist, der den Hohlraum (19) ausfüllt und die beiden Kontakte (13, 14) hochspannungsfest voneinander trennt.

8. Wandleranordnung nach Anspruch 7, **dadurch gekennzeichnet, daß** der Blindstecker (42) mit einem Deckelteil (43) verbunden ist, das statt des Deckels (22) mit dem Wandlergehäuse (1) verschraubbar ist.

## Claims

1. A transducer arrangement with a transducer housing (1) accommodating a voltage transducer (4) and with a first electrical connection (6) for the connection of the transducer arrangement to a high-voltage installation, said first electrical connection being electrically connected to the voltage transducer (4) and led out of the transducer housing (1),
wherein a separating device (16), for the temporary interruption of the electrical connection between voltage transducer (4) and the first electrical connection (6), is accessible from outside the transducer housing (1) and is arranged in the transducer housing (1), **characterised in that** the transducer housing (1) is designed in cast resin (2), that the separating device (12) comprises two contacts (13, 14) which are cast into the cast resin (2), and a cavity (19) into which a bridge element (20) serving for the electrical connection of the contacts (13, 14) may be inserted.

2. A transducer arrangement according to claim 1, **characterised in that** the cavity (19) accessible from the outside through the introduction opening (21) of the transducer housing (1) is designed in a conical manner, and the bridge element (20) is designed in a rod-like manner, that the contacts (13, 14) are arranged at the axial ends of the cavity (19) and that the bridge element (20) may be axially led into and out of the conical cavity (19) through the introduction opening (21).

3. A transducer arrangement according to claim 2, **characterised in that** the introduction opening (21) is sleeve-like, preferably in the form of a conventional high-voltage plug socket and may be closed by way of a lid (22).

4. A transducer arrangement according to claim 3, **characterised in that** a cable dummy plug (41) is arranged in the introduction opening (21) between the bridge element (20) and the lid (22).

5. A transducer arrangement according to one of the preceding claims, **characterised in that** the bridge element (20) on insertion may be pressed onto a first contact (13) of the previously mentioned two cast-in contacts (13, 14), said first contact being arranged opposite the introduction opening (21), by way of an axially acting spring element (23).

6. A transducer arrangement according to one of the preceding claims, **characterised in that** a second contact (14) of the previously mentioned two cast-in contacts (13, 14), which is arranged at that end of the cavity (19) facing the introduction opening (21) is designed as a contact ring (24) with a through opening and with axially acting contact elements.

7. A transducer arrangement according to one of the preceding claims, **characterised in that** the cavity (19) in the separation condition may be provided with a special dummy plug (42) of an elastic material instead of the removed cable dummy plug (41) and bridge element (20), and this special dummy plug fills out the cavity (19) and separates the two contacts from one another in a manner which is stable with regard to high-voltage.

8. A transducer arrangement according to claim 7, **characterised in that** the dummy plug (42) is connected to a lid part (43) which may be screwed to the transducer housing (1) instead of to the lid (22).

## Revendications

1. Ensemble transformateur comprenant un boîtier de transformateur (1) recevant un transformateur de tension (4), et une première connexion électrique (6) sortant du boîtier de transformateur (1) et électriquement reliée au transformateur de tension (4) pour connecter l'ensemble transformateur à une installation haute tension, le boîtier de transformateur (1) logeant un dispositif de séparation (12) pouvant être actionné depuis l'extérieur du boîtier de transformateur (1) pour couper temporairement la liaison électrique entre le transformateur de tension (4) et la première connexion électrique (6),
**caractérisé en ce que**
le boîtier de transformateur (1) est en résine de coulée (2) et le dispositif de séparation (12) présente deux contacts (13, 14) coulés dans la résine de coulée (2) et un espace creux (19), dans lequel est disposé un élément de pont (20) servant à la liaison électrique entre les contacts (13, 14).

2. Ensemble transformateur selon la revendication 1,
**caractérisé en ce que**
l'espace creux (19) accessible de l'extérieur à travers une ouverture d'introduction (21) du boîtier de transformateur (1) présente une forme de cône et l'élément de pont (20) une forme de barre, les contacts (13, 14) sont disposés aux extrémités axiales de l'espace creux (19), et l'élément de pont (20) peut être axialement introduit dans et extrait de l'espace creux conique (19) à travers l'ouverture d'introduction (21).

3. Ensemble transformateur selon la revendication 2,
**caractérisé en ce que**
l'ouverture d'introduction (21) présente la forme d'une douille, de préférence la forme d'une prise haute tension conventionnelle, et peut être fermée au moyen d'un couvercle (22).

4. Ensemble transformateur selon la revendication 3,
**caractérisé en ce que**
l'ouverture d'introduction (21), entre l'élément de pont (20) et le couvercle (22), renferme une fiche isolante de câble (41).

5. Ensemble transformateur selon l'une quelconque des revendications précédentes,
**caractérisé en ce que**
l'élément de pont (20), lors de l'enfichage, peut être appliqué par un élément élastique (23) agissant axialement contre un premier contact (13) des deux contacts (13, 14) coulés précités, disposé en regard de l'ouverture d'introduction (21).

6. Ensemble transformateur selon l'une quelconque des revendications précédentes,
**caractérisé en ce qu'**
un deuxième contact (14) des deux contacts (13, 14) coulés précités, disposé à l'extrémité de l'espace creux (19) en regard de l'ouverture d'introduction (21), présente la forme d'une bague de contact (24) avec ouverture de passage et éléments de contact agissant axialement.

7. Ensemble transformateur selon l'une quelconque des revendications précédentes,
**caractérisé en ce qu'**
on peut remplacer dans l'espace creux (19), à l'état séparé, la fiche isolante de câble (41) et l'élément de pont (20) par une fiche isolante spéciale (42) en matériau élastique, qui remplit l'espace creux (19) et sépare les deux contacts (13, 14) l'un de l'autre de manière résistante à la haute tension.

8. Ensemble transformateur selon la revendication 7,
**caractérisé en ce que**
la fiche isolante (42) est reliée à un élément de couvercle (43) qui peut être vissé au boîtier de transformateur (1) en remplacement du couvercle (22).
